# EUROPEAN PATENT APPLICATION

(11) **EP 1 441 286 A1**
(43) Date of publication of application: **28.07.2004**
(21) Application number: 03300207.2
(22) Date of filing: 10.11.2003
(51) Int. Cl.: G06F 9/445, G06F 13/00, H04L 12/28

(54) **Method for operating a network of interface nodes, and an interface device**

(30) Priority: 22.01.2003 DE 10302363
(71) Applicant: Thomson Licensing S.A., 92100 Boulogne-Billancourt (FR)
(72) Inventor: Brune, Thomas, 30449 Hannover (DE); Schweidler, Siegfried, 30989 Gehrden (DE); Gaedke, Klaus, 30659 Hannover (DE)
(74) Representative: Rittner, Karsten, Dr.

(57) **Abstract**

The invention relates to a method for operating a network of interface nodes (3), in particular IEEE 1394 interface nodes, and to an interface device for carrying out the method. In the network, interface nodes (3) are connected via a data bus (1). At least one of the interface nodes (3) in each case receives self-ID information from others of the interface nodes (3), with the self-ID information comprising self-ID data. The at least one of the interface nodes (3) forms joint information with joint header data and joint ID data for the self-ID information which has been received from the others of the interface nodes (3), and writes the joint information to a memory device in the at least one of the interface nodes (3).

## Description

The invention relates to a method for operating a network of interface nodes, and to an interface device, in particular in conjunction with IEEE 1394 interfaces.

### Background of the invention

Interfaces are used in conjunction with electrical/electronic appliances in order to allow the individual appliance to communicate electronically, in particular to transmit and to receive electronic data, which is generally transmitted via a data bus that is connected to the appliance. Various standards for interface configuration exist, depending on the data bus that is used and on the electrical/electronic appliances which are connected to the data bus. One interface standard which has gained particular attention in recent times is the IEEE 1394 Standard. IEEE 1394 provides a Standard which is particularly suitable for supporting data interchange between multimedia devices of any desired type. A data bus which is configured in accordance with the IEEE 1394 Standard can be connected both to peripherals of a computer such as printers, scanners, CD-RW drives and hard disks as well as to domestic electronic appliances such as video cameras or televisions. This Standard is therefore expected to have a major influence on the digitalization of electronic appliances.

In the IEEE 1394 Standard, a reset operation (bus reset) is carried out on a data bus when an electronic appliance is connected to the data bus, an electronic appliance is disconnected from the data bus, or when the number of interface nodes which are connected to the data bus increases. When a reset operation occurs on the data bus, each IEEE 1394 interface node which is connected to the data bus sends self-ID information (ID identification) to the other interface nodes. This ensures that each interface node in a network of interface nodes which are connected via the data bus is informed of which other interface nodes are connected to the network. The self-ID information is used by each interface node to identify itself to the other interface nodes in the network. The self-ID information which is received from each of the other interface nodes allows each interface node in the network to produce a so-called interface node list and to store this in a memory device which is associated with that particular interface node. This stored information can then be processed by a driver program for the respective interface node for the management of the data packets which can be transmitted and can be received via the data bus.

When a relatively large number of interface nodes are connected to a data bus and are used for coupling of a respective electrical/electronic appliance, the number of reset operations on the data bus increases since appliances are connected to the data bus, or are disconnected from it, relatively frequently. Each such action leads to a specific reset operation on the data bus. A large number of reset operations in a short time, which is also referred to as a "reset operation storm", may, for example, also occur as a result of a chattering contact in one of the interface nodes, since the chattering contact leads to the associated appliance being continuously coupled and disconnected via the interface nodes, and this initiates a reset operation whenever it occurs. However, appliances also exist which are programmed such that they initiate a bus reset operation two or more times successively when they cannot establish themselves as a root node in the configuration phase. If an appliance such as this is located in a network, this could likewise result in a "reset operation storm". Since, in accordance with the IEEE 1394 Standard, every reset operation on the data bus results in the transmission of a self-ID information data packet by each of the connected interface nodes, this leads to a large number of self-ID information items having to be received and stored for each reset operation in each of the interface nodes.

A method for operating a data transfer control device in accordance with the IEEE 1394 Standard is known from the document EP 1 120 936 A1. In the known method, the data transfer control device produces identification information in order to determine whether a received data packet and a subsequent received data packet have been received at times during which various reset operations were taking place on the data bus. Each data packet which has been received by the data transfer control device is stored together with the identification information that is produced in a memory device. When the received and stored data packets are subsequently accessed, the identification information provides information about which reset operation was carried out during reception of the respective data packet. This information can be used during processing of the data packet, for example with the aid of firmware. On the other hand, however, the known method leads to an increased amount of stored data.

Since each interface node in the network of interface nodes stores in its associated memory the self-ID information which is received on the data bus from the other interface nodes in the event of a reset operation, the driver program for the interface node can subsequently access the stored self-ID information in order to take this into account during the transmission and reception of data packets via the data bus.

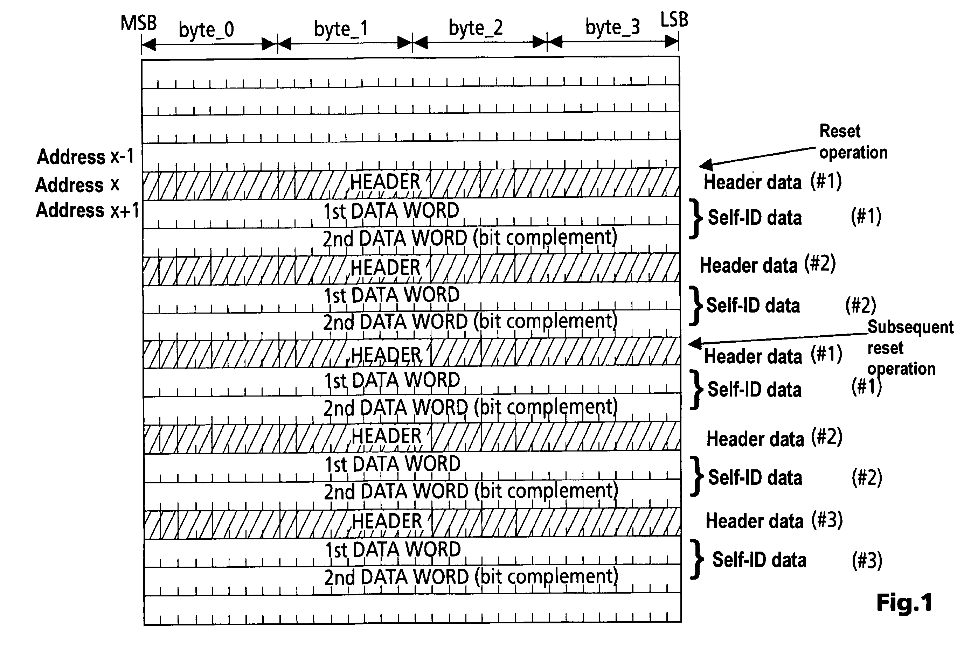

The received self-ID information is in this case generally stored in such a way that header data and self-ID data are stored for each self-ID information item, as is illustrated schematically in Figure 1. As illustrated in Figure 1, each of the self-ID data items comprises a first and a second data word, each having a data word length of four bytes (quadlets). The second data word is the complement of the first data word, and is used for checking purposes.

If two or more reset operations occur on the data bus within a short time, this leads to two or more groups of received self-ID information items being stored in the respective memory device in the interface nodes of the network, with each of the groups being associated with a specific reset operation on the data bus. Generally, however, only the self-ID information which has been received since the last reset operation need be taken into account by the driver program for the interface node. In order to evaluate the stored self-ID information, the driver program can search through the stored self-ID information in the memory device for a rising address order. However, this leads to the driver program processing every self-ID information item without knowing that this is not the last self-ID information for the associated interface node. A procedure such as this leads to a loss of computation power, since each individual self-ID information item must be processed for each of the interface nodes in the network.

Alternatively, the driver program could search the self-ID information in the memory device for a decreasing address order. In this case, however, the driver program would need to be designed to be more complex. Searching through the memory device in this way requires increased complexity. Both possible procedures have the common feature that the memory device for each interface node is occupied by a large number of self-ID information items when reset operations occur frequently on the data bus.

### Invention

The object of the invention is therefore to specify a method for operating a network of interface nodes, and an interface device, which allow more efficient use of the self-ID information, which is produced as a result of a reset operation on the data bus, for each interface node in the network, in particular in the case of so-called reset operation storms, that is to say when a large number of reset operations occur in a short time on the data bus.

The invention is achieved by a method having the features as claimed in the independent claim 1, and by an interface device having the features as claimed in the independent claim 6.

The invention is based on the idea of forming joint information with joint header data and joint ID data for the self-ID information items which are received by an interface node after a reset operation on the data bus, and of storing this joint information in the memory device of the interface node. This allows the received self-ID information items to be compiled to form joint information which is optimized with regard to the memory requirement that is needed for this purpose, and with regard to the computation power which is needed for subsequent processing of the joint information by a driver program for the associated interface node. Optimization is in this case carried out for the self-ID data for each self-ID information item. This makes it possible to reduce the memory requirement in the memory device for the associated interface node. The joint information can be stored in the memory device such that the driver program for the interface node is informed as efficiently as possible of the current interface node configuration of the network during the processing of the joint information.

One expedient refinement of the invention can provide for the self-ID data for the respective self-ID information to comprise a first data word and a second data word, with the second data word being the complement of the first data word, for the second data word to be processed in the at least one of the interface nodes in a continuous operating mode (on the fly) for error checking of the first data word, and for the first data word to be in each case transferred to the joint ID data during the formation of the joint information when no errors are found during the checking of the second data word. This makes it possible to save the memory requirement for the second data word, which is intended for error checking, during the storage of the joint information.

In order to inform a driver program for the interface node as far as possible without any time delay of the updating of the joint information relating to the configuration of the interface nodes which are connected to the network, one preferred embodiment of the invention provides that, once the process of writing the joint information to the memory device has been completed, information about the completion of the process of writing the joint information is transmitted to a driver program for the at least one of the interface nodes, in order to release the joint information for processing with the aid of the driver program.

If two or more reset operations occur on the data bus in a short time during operation of the interface node, situations can arise in which a further reset operation which follows the previous reset operation and the self-ID information associated with this are received by the other interface nodes before the formation and/or writing of the joint information to the memory device for the previous reset operation have/has been completed. One advantageous refinement of the invention provides that the formation of the joint information and/or the writing of the joint information to the memory device is terminated when the at least one of the interface nodes receives information about a further reset operation on the data bus during the formation of the joint information and/or the writing of the joint information to the memory device. This prevents computation power and memory being consumed for the joint information relating to the previous reset operation, which is then no longer up to date, after receiving the subsequent reset operation.

In order to reduce the memory requirement that is needed, one preferred development of the invention provides that older joint information is overwritten when the joint information is written to the memory device, this older joint information being the joint information which was written at least partially to the memory device before the process of writing the joint information. In this way, during the writing of the joint information for the subsequent reset operation, the joint information for the previous reset operation can be overwritten, so that this minimizes the memory requirement needed for storing the joint information.

The features of developments in the dependent claims of the interface device have, in a corresponding manner, the advantages mentioned in conjunction with associated features in the dependent method claims.

### Drawings

The invention will be explained in more detail in the following text using an exemplary embodiment and with reference to drawings, in which:
- Figure 1: shows a schematic illustration of a known memory organization;
- Figure 2: shows an example of an IEEE 1394 network with various entertainment electronic appliances;
- Figure 3: shows an illustration of the timing of two or more successive bus reset procedures for the network shown in Figure 2;
- Figure 4: shows a schematic illustration of a network of electrical/electronic appliances, which are connected via a data bus with the aid of IEEE 1394 interfaces in each case;
- Figure 5: shows a more detailed schematic illustration of an interface node; and
- Figure 6: shows a schematic illustration of a memory organization using the interface node as shown in Figure 5.

### Exemplary embodiments

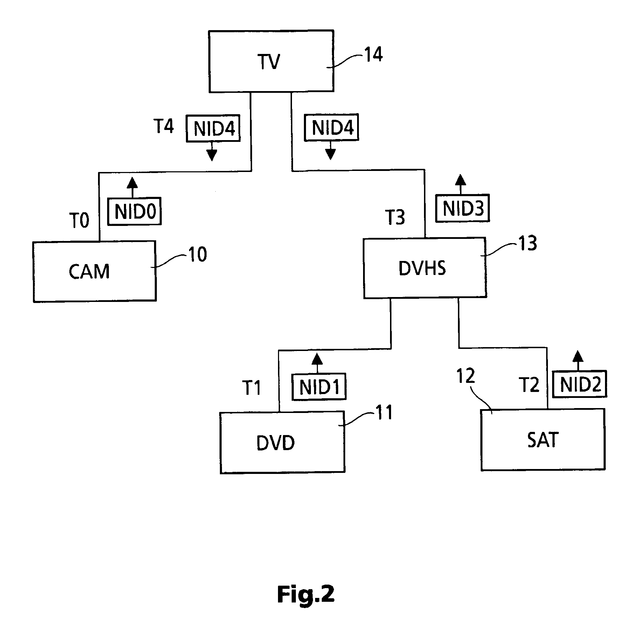

Figure 2 shows an example of an IEEE 1394 network with entertainment electronic appliances. The reference number 10 denotes a camcorder, the reference number 11 a DVD player, the reference number 12 a satellite receiver, the reference number 13 a digital video recorder, which, in the illustrated case, is a DVHS recorder, and the reference number 14 denotes a television. The sequence of transmission of the self-identification data packets after a bus reset process is specified as a standard by its network structure in an IEEE 1394 network. In the illustrated structure, the bus is first of all allocated to the camcorder 10, then to the DVD player 11, after which it is allocated to the satellite receiver 11, and then to the DVHS recorder 13 and only then to the television 14. The sequence of transmission of each of the self-identification data packets with the node identification numbers NIDO - NID4 is likewise shown in Figure 2.

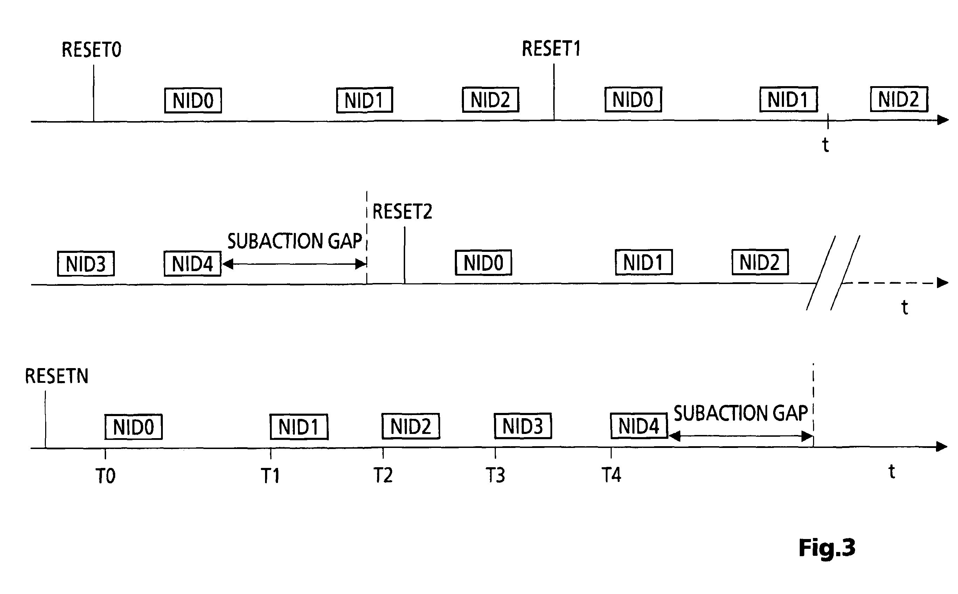

Figure 3 shows the occurrence of two or more successive bus reset processes for the example of a network as shown in Figure 2. Although all the self-identification data packets are transmitted in order after the second reset process RESET1, the firmware for the DVHS recorder initiates a further reset process RESET2, however, after waiting for the so-called subaction gap that is provided in the Standard, because the appliance was not able to operate as a root appliance. The DVHS appliance does not give up this right, in the example, until further reset processes have been carried out without any result, that is to say after the reset process RESET N.

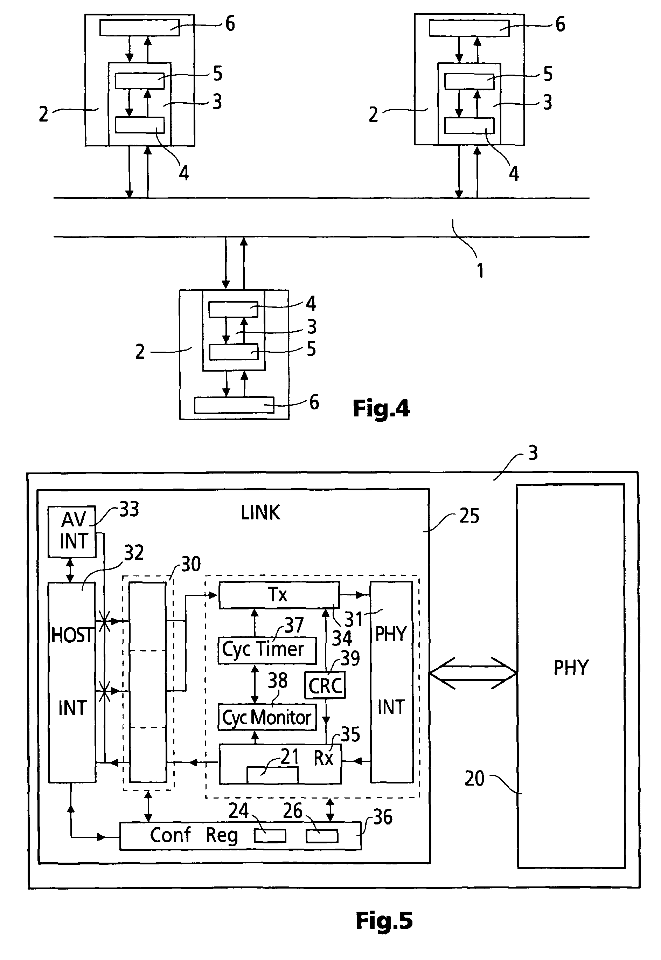

Figure 4 shows a schematic illustration of a network in which two or more apparatuses 2 are connected to a data bus 1 via a respective interface node 3 for transmission/reception of data packets via the data bus 1. Each of the interface nodes 3 is in the form of an IEEE 1394 interface node which, in particular, allows the coupling/decoupling of the apparatuses 2 and data packets to be interchanged between the apparatuses 2 which are connected to the data bus 1. The interface device has hardware means 4 and software means 5 for operation of the hardware means 4. The hardware means 4 are used in particular for transmission and for reception of data packets via the data bus 1. The software means 5 comprise, in particular, a driver program for operation of the hardware means 4, in order to provide the functionalities of the interface node 3. The software means 5 are typically formed by an IEEE 1394 software stack for the various layers in accordance with the OSI/ISO reference model for data communication.

Application software 6 which is in each case installed in the apparatus 2 is used by the interface node 3 in order to send or to receive data packets via the data bus 1.

Details relating to the design and configuration of an interface in accordance with the IEEE 1394 Standard are known to those skilled in the art and will therefore not be explained in any detail here. For example, an IEEE 1394 interface has hardware means for the two lower layers of the OSI/ISO reference model. These are the bit transmission layer (physical layer) and the data protection layer (data link layer). Since the Standard specifies DC isolation between the two lower layers, two separate ICs are normally used for this purpose, that is to say for the physical layer IC and for the data link layer IC. The higher layers are provided by software means.

Figure 5 shows a schematic illustration to explain the operation of the respective interface node 3 in the network illustrated in Figure 1. When a reset operation (bus reset) occurs on the data bus 1, this leads to every apparatus 2 which is connected to the data bus 1 sending self-ID information via the data bus 1 to the other apparatuses 2 which are connected to the data bus 1. A reset operation on the data bus 1 is initiated, in particular, when one of the apparatuses 2 is disconnected from the data bus 1, or is connected to the data bus 1. The aim of the transmission of the respective self-ID information is for all the interface nodes 3 which are connected to the data bus 1 always to be informed, on an up-to-date basis, of which interface nodes 3 are coupled to the data bus 1, so that data packets can be transmitted to the interface nodes 3 which are coupled to it, and can be received from them.

Figure 5 shows a block diagram of a network interface 3 which contains the two ICs mentioned above, the physical layer IC 20 (PHY-IC for short) and the link layer IC 25 (LINK-IC for short). The part which is essential to the invention is contained in the LINK-IC 25. The structure of the PHY-IC 20 will therefore not be described in any more detail in the following text. A commercially available PHY-IC may be used for this purpose. The structure of the LINK-IC 25 is based on the structure of the LINK-IC with the designation TSB 12LV01A from Texas Instruments. With regard to the disclosure of this structure, reference is therefore expressly made to the description of this IC in the data sheet. The LINK-IC 25 contains an interface 31 for the bit transmission layer (physical layer interface). The IC likewise contains an interface 32 for an external application processor. In addition, the IC contains a further interface, referred to as an AV interface 33, via which the audio and video data is passed from an application process to the IC. The internal memory is denoted by the reference number 30, and is subdivided into three sections. Each section is in the form of a FIFO. Two of the sections are intended for use as the memory for data transmission, while only one area is intended for reception of data packets. A transmission unit 34 and a receiving unit 35 are also accordingly provided in the link-IC 18. A cycle counter 37 is also shown, as a separate unit, and its count is in each case monitored by a monitor circuit 38 for generating the time markers for the data source packets to be transmitted. In addition, a checking unit 39 is also provided which, for example, carries out the evaluation of the CRC code when a bus packet is received, or else calculates the associated CRC code when a bus packet is to be transmitted. The entire IC also contains configuration and status registers 36, which make it possible to control the IC without a dedicated processor.

The self-ID information data packets are received in the interface node 3 from the receiving unit 35. The two or more received self-ID information items are then processed with the aid of processing means 21, in such a way that self-ID data in the respective self-ID information packet is composed to form joint information with joint header data and joint ID data in the correspondingly reserved area of the memory 30. The self-ID data in each self-ID information packet in this case normally includes not only the header part but also a first and a second data word, each having four bytes. The second data word is the complement of the first data word, and is used for error checking of the first data word. During the processing of the self-ID information packets with the aid of the processing means 21, each second data word in the self-ID data is used for error checking in a continuous operating mode (on the fly). If no errors have been found during the check of the second data word with the aid of the checking unit 39, the associated first data word is transferred to the joint ID data in the joint information.

Furthermore, joint header data is compiled with the aid of the processing means 21. The joint header data and the joint ID data are then written as joint information to the memory device 30 for the LINK-IC 25. Finally, this results in a large packet comprising joint header data and joint ID data. The joint header data includes, for example, information about the scope and the length of the joint information, and information that this is followed by self-ID data (identifier).

The formation of the joint information and the writing of the joint information to the memory device 23 can be carried out successively or, at least partially, parallel in time. The joint information is always compiled for the self-ID information which is received from the respective interface node 3 and is associated with the reset operation occurring on the data bus 1. If a further reset operation is received from the interface nodes 3 during the formation of the joint information and/or during the writing of the joint information to the memory device 30, then the process which has been carried out for formation/writing of the joint information is terminated. New joint information is then produced with the aid of the processing means 21, taking into account the self-ID information which has been received after the further reset operation. The termination of a current operation for formation/writing of the joint information is carried out with the aid of interruption means 24 in the LINK-IC 25. If a joint information item has been formed completely and has been installed completely in the memory device 30, then the signaling means 26 automatically produce electronic termination information, for example in the form of an interrupt, which is transmitted to the driver program 5, so that the completely stored joint information is released for further processing by the driver program 5. During possible processing, the driver program 5 can use the joint header data in particular to determine that this is valid information.

As is shown in Figure 5, the LINK-IC 25 comprises a transmission unit 34 which is used to send the self-ID information from the interface node 3 via the data bus 1 when a reset operation occurs on the data bus 1. The receiving unit 35, the processing means 21, the memory device 30, the interruption means 24, the signaling means 26, the transmission unit 34 and the checking unit 39 are implemented in the LINK-IC 25 with the aid of software and/or hardware components.

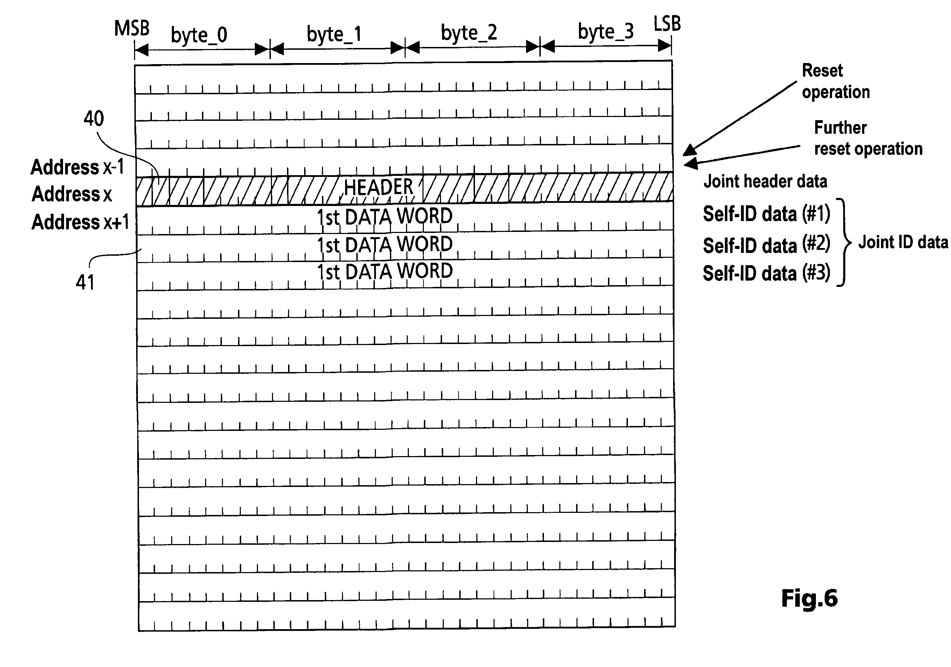

Figure 6 shows a schematic illustration of a memory organization for the memory device 30, when the self-ID information which has been received from the interface node 3 is processed in the manner explained with reference to Figure 4 to form joint information, and is then written to the memory device 30. As is shown in Figure 6, the memory device 30 comprises two or more addresses. Joint information is stored starting with an address x. The joint information starts with joint header data 40, which comprises four bytes. The joint header data 40 is followed by joint ID data 41, which comprises the first data words of the self-ID data which has been received from the interface node 3. Each of the data words which are included in the joint ID data 41 is associated with one of the received self-ID information packets which the associated interface node has received after a reset operation on the data bus 1. As is shown in Figure 6, no provision is made for storage of the second data word, which likewise comprises the respective self-ID information, so that memory space is saved in comparison to the known memory organization as explained above and as shown in Figure 1.

Furthermore, only a single joint information item together with joint header data and joint ID data and which is associated with the most recent reset operation is stored in the memory device 30 (see Figure 1) as illustrated in Figure 6. The data is gathered by the processing means 21 such that, once the bus reset has occurred, the first data word of a received self-ID information packet is in each case written to the memory 30, starting from the address x+1. The joint header data information is not collated until the reset phase has been completed, and is then written to the address X in the memory 30. The joint header data information includes not only the statement that this is self-ID information data but also the statement relating to the length of the collated packet with the self-ID data information. In contrast to the memory organization shown in Figure 1, only information relating to the current reset operation is located in the memory device 30. This leads to a further reduction in the memory requirement in the memory device 30, and to an improvement in performance.

The described method for operating an interface node, as well as an interface device for carrying out the method, have been described in conjunction with the IEEE 1394 Standard. However, they can be used in conjunction with any desired interface standards with similar configuration characteristics to the IEEE 1394 Standard, in order to achieve the explained advantages. For the consumers, they improve the usefulness of the IEEE 1394 Standard or similar standards for any desired electrical/electronic appliances such as computers, printers, scanners, CD drives, hard disk drives and domestic electronic appliances such as video cameras or televisions.

## Claims

1. A method for operating a network of interface nodes (3), in particular IEEE 1394 interface nodes, in which interface nodes (3) are connected via a data bus (1), with at least one of the interface nodes (3) in each case receiving self-ID information from others of the interface nodes (3) after a reset operation on the data bus (1), and with each self-ID information item comprising self-ID data, wherein joint information with joint header data and joint ID data is formed in the at least one of the interface nodes (3) for the self-ID information which has been received by the other interface nodes (3), and is stored in a memory device (23) in the at least one interface node (3).

2. The method as claimed in claim 1, wherein the self-ID data for the respective self-ID information comprises a first data word and a second data word with the second data word being the complement of the first data word, wherein the second data word is processed in the at least one of the interface nodes (3) in a present operating mode for error checking of the first data word, and wherein the first data word is in each case transferred to the joint ID data, forming the joint information, when no error is found during the checking of the second data word.

3. The method as claimed in claim 1 or 2, wherein, once the process of writing the joint information to the memory device (23) has been completed, information about the completion of the process of writing the joint information is transmitted to a driver program (5) for the at least one of the interface nodes (3), in order to release the joint information for processing with the aid of the driver program (5).

4. The method as claimed in one of the preceding claims, wherein the formation of the joint information and/or the writing of the joint information to the memory device (30) is terminated when the at least one of the interface nodes (3) receives information about a further reset operation on the data bus (1) during the formation of the joint information and/or the writing of the joint information to the memory device (30).

5. The method as claimed in one of the preceding claims, wherein older joint information is overwritten when the joint information is written to the memory device (30), this older joint information being the joint information which was written at least partially to the memory device (30) before the process of writing the joint information.

6. An interface device (3), in particular an IEEE 1394 interface, which is coupled to a data bus (1), having:
- transmission means (34) for transmitting self-ID information to other interface devices in a network of interface devices;
- receiving means (35) for reception of respective self-ID information from the other interface devices in the network of interface devices after a reset operation on the data bus (1), with the respective self-ID information comprising self-ID data;
- processing means (21) for forming joint information with joint header data and joint ID data on the basis of the self-ID information which is received from the other interface devices; and
- writing means for writing the joint information to a memory device (30).

7. The interface device (3) as claimed in claim 6, wherein the self-ID data in the respective self-ID information comprises a first data word and a second data word, with the second data word being the complement of the first data word, and wherein the processing means (21) have associated test means (39) in order to use the second data word in a continuous operating mode for error checking of the first data word.

8. The interface device (3) as claimed in claim 6 or 7, distinguished by signaling means (25) for formation and for transmission of terminating information to a driver program (5) after completion of the process of writing the joint information to the memory device (30), in order to release the joint information for processing with the aid of the driver program (5).

9. The interface device (3) as claimed in one of claims 6 to 8, distinguished by interruption means (24) in order to interrupt the formation of the joint information and/or the writing of the joint information to the memory device (30) when information about a further reset operation on the data bus (1) is received during the formation of the joint information with the aid of the processing means (21).
